# EUROPEAN PATENT APPLICATION

(11) **EP 4 408 138 A1**
(43) Date of publication of application: **31.07.2024**
(21) Application number: 23220557.5
(22) Date of filing: 28.12.2023
(51) Int. Cl.: H10K 50/19, H10K 59/38, H10K 59/80, H10K 50/81, H10K 102/00

(54) **ORGANIC LIGHT EMITTING DEVICE**

(30) Priority: 30.01.2023 KR 20230011774
(71) Applicant: LG Display Co., Ltd., Seoul 07336 (KR)
(72) Inventor: CHOI, Hong-Seok, 10845 Gyeonggi-do (KR); AHN, Byung-Gun, 10845 Gyeonggi-do (KR); CHO, Myeong-Seon, 10845 Gyeonggi-do (KR)
(74) Representative: Ter Meer Steinmeister & Partner

(57) **Abstract**

The present disclosure relates to an organic light emitting device comprising a substrate including red, green and blue pixel regions; and an organic light emitting diode including an anode, a cathode over the anode and an organic emitting layer between the anode and the cathode and corresponding to in the red, green and blue pixel regions, wherein the organic emitting layer includes a first emitting part including a red emitting material layer, a second emitting part including a green emitting material layer and positioned between the first emitting part and the cathode and a third emitting part including a blue emitting material layer and positioned between the second emitting part and the cathode, and wherein the anode in the blue pixel region has a first thickness, and the anode in the green pixel region has a second thickness being 2/5 to 2/3 of the first thickness.

## Description

The present application claims the benefit of Korean Patent Application No. 10-2023-0011774 filed in the Republic of Korea on January 30, 2023.

### FIELD OF TECHNOLOGY

The present disclosure relates to an organic light emitting device, and more specifically, to an organic light emitting device having high emitting efficiency and high color gamut (color reproductivity).

### BACKGROUND

As requests for a flat panel display device having a small occupied area have been increased, an organic light emitting display device including an OLED has been the subject of recent research and development.

The OLED emits light by injecting electrons from a cathode as an electron injection electrode and holes from an anode as a hole injection electrode into an emitting material layer (EML), combining the electrons with the holes, generating an exciton, and transforming the exciton from an excited state to a ground state. A flexible substrate, for example, a plastic substrate, can be used as a base substrate where elements are formed. In addition, the organic light emitting display device can be operated at a voltage (e.g., 10V or below) lower than a voltage required to operate other display devices. Moreover, the organic light emitting display device has advantages in the power consumption and the color sense.

Recently, a white OLED including a first emitting part, which includes a blue EML, a second emitting part, which includes a red EML and a green EML, and a third emitting part, which includes a blue EML, is introduced. However, in the white OLED, a color uniformity is degraded by the first and third emitting parts each including the blue EML.

### SUMMARY

The present disclosure is directed to an organic light emitting device that substantially obviates one or more of the problems associated with the limitations and disadvantages of the related conventional art.

Additional features and advantages of the present disclosure are set forth in the description which follows, and will be apparent from the description, or evident by practice of the present disclosure. The objectives and other advantages of the present disclosure are realized and attained by the features described herein as well as in the appended drawings.

The object is solved by the features of the independent claims. Preferred embodiments are given in the dependent claims.

To achieve these and other advantages in accordance with the purpose of the embodiments of the present disclosure, as described herein, an aspect of the present disclosure is an organic light emitting display device comprising a substrate including red, green and blue pixel regions; and an organic light emitting diode including an anode, a cathode over the anode and an organic emitting layer between the anode and the cathode and corresponding to in the red, green and blue pixel regions, wherein the organic emitting layer includes a first emitting part including a red emitting material layer, a second emitting part including a green emitting material layer and positioned between the first emitting part and the cathode and a third emitting part including a blue emitting material layer and positioned between the second emitting part and the cathode, and wherein the anode in the blue pixel region has a first thickness, and the anode in the green pixel region has a second thickness being 2/5 to 2/3 of the first thickness.

In the following optional features are provided which can be combined with the above mentioned aspect alone or in combination or in sub combination.

In one or more embodiments, the first thickness may be 1/4 of a blue wavelength in the anode, the blue wavelength in the anode means λ_{B}/n, wherein λ_{B} is a wavelength of the blue light, n is a refractive index of the anode.

In one or more embodiments, the first thickness may be in a range of 500 to 600Å.

In one or more embodiments, the second thickness may be in a range of 200 to 400Å.

In one or more embodiments, a distance between a lower surface of the green emitting material layer and a lower surface of the cathode may be in a range of 180 to 230nm.

In one or more embodiments, a distance between a lower surface of the blue emitting material layer and a lower surface of the cathode may be in a range of 45 to 65nm.

In one or more embodiments, a distance between a lower surface of the red emitting material layer and a lower surface of the cathode may be in a range of 415 to 445nm.

In one or more embodiments, the first emitting part may further include a first hole transporting layer under the red emitting material layer, a hole injection layer under the first hole transporting layer and a first electron transporting layer on the red emitting material layer.

In one or more embodiments, the second emitting part may further include a second hole transporting layer under the green emitting material layer and a second electron transporting layer on the green emitting material layer.

In one or more embodiments, the third emitting part may further include a third hole transporting layer under the blue emitting material layer, a third electron transporting layer on the blue emitting material layer and an electron injection layer on the third electron transporting layer.

In one or more embodiments, a thickness of the third hole transporting layer may be greater than a thickness of the first hole transporting layer and/or may be smaller than a thickness of the second hole transporting layer.

In one or more embodiments, the thickness of the second hole transporting layer may be in a range of 125 to 165nm.

In one or more embodiments, the thickness of the third hole transporting layer may be in a range of 45 to 85nm.

In one or more embodiments, the thickness of the first hole transporting layer may be in a range of 25 to 35nm.

In one or more embodiments, the thickness of the second hole transporting layer may be in a range of 125 to 165nm.

In one or more embodiments, the thickness of the third hole transporting layer may be in a range of 45 to 85nm.

In one or more embodiments, a thickness of the first electron transporting layer may be greater than a thickness of the second electron transporting layer and/or may be smaller than a thickness of the third electron transporting layer.

In one or more embodiments, the thickness of the first electron transporting layer may be a range of 20 to 30nm.

In one or more embodiments, the thickness of the second electron transporting layer may be a range of 15 to 25nm.

In one or more embodiments, the thickness of the third electron transporting layer may be a range of 25 to 35nm.

In one or more embodiments, the anode in the red pixel region may have a third thickness being same as the first thickness or the second thickness.

In one or more embodiments, the organic emitting layer further may include a first charge generation layer between the first and second emitting parts and a second charge generation layer between the second and third emitting parts.

In one or more embodiments, the organic light emitting device may comprise a color filter layer corresponding to the red, green and blue pixel regions and positioned between the substrate and the organic light emitting diode.

It is to be understood that both the foregoing general description and the following detailed description are exemplary and explanatory and are intended to further explain the present disclosure as claimed.

### BRIEF DESCRIPTION OF THE DRAWINGS

The accompanying drawings, which are included to provide a further understanding of the present disclosure and are incorporated in and constitute a part of this specification, illustrate embodiments of the present disclosure and together with the description serve to explain the principles of the present disclosure.
FIG. 1 is a schematic circuit diagram illustrating an organic light emitting display device of the present disclosure.
FIG. 2 is a schematic cross-sectional view illustrating an organic light emitting display device according to the present disclosure.
FIG. 3 is a schematic cross-sectional view illustrating an OLED of an organic light emitting display device according to a first embodiment of the present disclosure.
FIG. 4 schematic view illustrating a constructive interference of blue emission in the OLED of the display device of the first embodiment of the disclosure.
FIG. 5 is a schematic cross-sectional view illustrating an OLED of an organic light emitting display device according to a second embodiment of the present disclosure.
FIG.6 graph showing an emission intensity depending on the anode thickness in an OLED.

### DETAILED DESCRIPTION

Reference will now be made in detail to aspects of the present disclosure, examples of which may be illustrated in the accompanying drawings. In the following description, when a detailed description of well-known functions or configurations related to this document is determined to unnecessarily cloud a gist of the inventive concept, the detailed description thereof will be omitted. The progression of processing steps and/or operations described is an example; however, the sequence of steps and/or operations is not limited to that set forth herein and may be changed as is known in the art, with the exception of steps and/or operations necessarily occurring in a particular order. Like reference numerals designate like elements throughout. Names of the respective elements used in the following explanations are selected only for convenience of writing the specification and may be thus different from those used in actual products.

Advantages and features of the present disclosure and methods of achieving them will be apparent with reference to the aspects described below in detail with the accompanying drawings. However, the present disclosure is not limited to the aspects disclosed below, but can be realized in a variety of different forms, and only these aspects allow the disclosure of the present disclosure to be complete. The present disclosure is provided to fully inform the scope of the disclosure to the skilled in the art of the present disclosure.

The shapes, sizes, proportions, angles, numbers, and the like disclosed in the drawings for explaining the aspects of the present disclosure are illustrative, and the present disclosure is not limited to the illustrated matters. The same reference numerals refer to the same elements throughout the specification. In addition, in describing the present disclosure, if it is determined that a detailed description of the related known technology unnecessarily obscure the subject matter of the present disclosure, the detailed description thereof can be omitted. When 'including', 'having', 'consisting', and the like are used in this specification, other parts may be added unless 'only' is used. When a component is expressed in the singular, cases including the plural are included unless specific statement is described.

In construing an element, the element is construed as including an error or tolerance range although there is no explicit description of such an error or tolerance range.

In describing a position relationship, for example, when a position relation between two parts is described as, for example, "on," "over," "under," and "next," one or more other parts may be disposed between the two parts unless a more limiting term, such as "just" or "direct(ly)" is used.

In describing a time relationship, for example, when the temporal order is described as, for example, "after," "subsequent," "next," and "before," a case that is not continuous may be included unless a more limiting term, such as "just," "immediate(ly)," or "direct(ly)" is used.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

Features of various aspects of the present disclosure may be partially or overall coupled to or combined with each other, and may be variously inter-operated with each other and driven technically as those skilled in the art can sufficiently understand. The aspects of the present disclosure may be carried out independently from each other, or may be carried out together in co-dependent relationship.

Reference will now be made in detail to some of the examples and preferred embodiments, which are illustrated in the accompanying drawings.

In the present disclosure, an organic light emitting device including the OLED may be an organic light emitting display device or an organic lightening device. As an example, an organic light emitting display device, which is a display device including the OLED of the present disclosure, will be mainly described.

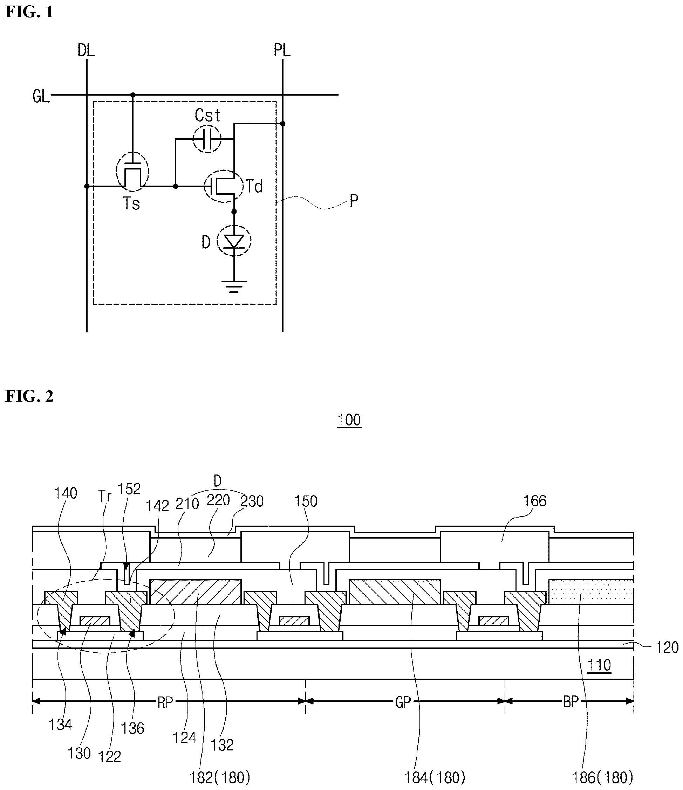

FIG. 1 is a schematic circuit diagram illustrating an organic light emitting display device of the present disclosure.

As illustrated in FIG. 1, a gate line GL and a data line DL, which cross each other to define a pixel region (pixel) P, and a power line PL are formed in an organic light emitting display device. A switching thin film transistor (TFT) Ts, a driving TFT Td, a storage capacitor Cst and an OLED D are formed in the pixel region P. The pixel region P may include a red pixel region, a green pixel region and a blue pixel region.

The switching thin film transistor Ts is connected to the gate line GL and the data line DL, and the driving thin film transistor Td is connected between the switching thin film transistor Ts and the power line PL. The storage capacitor Cst is connected to a gate electrode and a drain electrode of the driving TFT Td, and the OLED D is connected to the driving thin film transistor Td.

When the switching thin film transistor Ts is turned on by the gate signal applied through the gate line GL, the data signal applied through the data line DL is applied into a gate electrode of the driving thin film transistor Td and one electrode of the storage capacitor Cst through the switching thin film transistor Ts.

The driving thin film transistor Td is turned on by the data signal applied into the gate electrode so that a current proportional to the data signal is supplied from the power line PL to the OLED D through the driving thin film transistor Td. The OLED D emits light having a luminance proportional to the current flowing through the driving thin film transistor Td.

In this case, the storage capacitor Cst is charge with a voltage proportional to the data signal so that the voltage of the gate electrode in the driving thin film transistor Td is kept constant during one frame.

Therefore, the organic light emitting display device can display a desired image.

FIG. 2 is a schematic cross-sectional view illustrating an organic light emitting display device according to the present disclosure.

As illustrated in FIG. 2, the organic light emitting display device 100 includes a substrate 110, where a red pixel region RP, a green pixel region GP and a blue pixel region BP are defined, a TFT Tr on the substrate 110, an OLED D, which is disposed over the TFT Tr and connected to the TFT Tr, and a color filter layer 180 between the substrate 110 and the OLED D.

The substrate 110 may be a glass substrate or a flexible substrate. For example, the substrate 110 may be a polyimide (PI) substrate, a polyethersulfone (PES) substrate, a polyethylenenaphthalate (PEN) substrate, a polyethylene terephthalate (PET) substrate or a polycarbonate (PC) substrate.

A buffer layer 120 is formed on the substrate, and the TFT Tr, which respectively corresponds to the red, green and blue pixels RP, GP and BP, is formed on the buffer layer 120. The buffer layer 120 may be omitted, and the TFT Tr may be positioned on the substrate 110.

A semiconductor layer 122 is formed on the buffer layer 120. The semiconductor layer 122 may include an oxide semiconductor material or polycrystalline silicon. When the semiconductor layer 122 includes the oxide semiconductor material, a light-shielding pattern (not shown) may be formed under the semiconductor layer 122. The light to the semiconductor layer 122 is shielded or blocked by the light-shielding pattern such that thermal degradation of the semiconductor layer 122 can be prevented. On the other hand, when the semiconductor layer 122 includes polycrystalline silicon, impurities may be doped into both sides of the semiconductor layer 122.

A gate insulating layer 124 of an insulating material is formed on the semiconductor layer 122 and over an entire surface of the substrate 110. The gate insulating layer 124 may be formed of an inorganic insulating material such as silicon oxide (SiOx) or silicon nitride (SiNx).

A gate electrode 130, which is formed of a conductive material, e.g., metal, is formed on the gate insulating layer 124 to correspond to a center of the semiconductor layer 122. In FIG. 2, the gate insulating layer 124 is formed on an entire surface of the substrate 110. Alternatively, the gate insulating layer 124 may be patterned to have the same shape as the gate electrode 130.

An interlayer insulating layer 132, which is formed of an insulating material, is formed on the gate electrode 130 and over an entire surface of the substrate 110. The interlayer insulating layer 132 may be formed of an inorganic insulating material, e.g., silicon oxide or silicon nitride, or an organic insulating material, e.g., benzocyclobutene or photo-acryl.

The interlayer insulating layer 132 includes first and second contact holes 134 and 136 exposing both sides of the semiconductor layer 122. The first and second contact holes 134 and 136 are positioned at both sides of the gate electrode 130 to be spaced apart from the gate electrode 130. The first and second contact holes 134 and 136 are formed through the interlayer insulating layer 132 and the gate insulating layer 124. Alternatively, when the gate insulating layer 124 is patterned to have the same shape as the gate electrode 130, the first and second contact holes 134 and 136 is formed only through the interlayer insulating layer 132.

A source electrode 140 and a drain electrode 142, which are formed of a conductive material, e.g., metal, are formed on the interlayer insulating layer 132. The source electrode 140 and the drain electrode 142 are spaced apart from each other with respect to the gate electrode 130 and respectively contact both sides of the semiconductor layer 122 through the first and second contact holes 134 and 136.

The semiconductor layer 122, the gate electrode 130, the source electrode 140 and the drain electrode 142 constitute the TFT Tr, and the TFT Tr may be an n-type. The TFT Tr serves as a driving element. Namely, the TFT Tr may correspond to the driving TFT Td (of FIG. 1).

In the TFT Tr, the gate electrode 130, the source electrode 140, and the drain electrode 142 are positioned over the semiconductor layer 122. Namely, the TFT Tr has a coplanar structure. Alternatively, in the TFT Tr, the gate electrode may be positioned under the semiconductor layer, and the source and drain electrodes may be positioned over the semiconductor layer such that the TFT Tr may have an inverted staggered structure. In this instance, the semiconductor layer may include amorphous silicon.

The color filter layer 180 is formed on the interlayer insulating layer 132. The color filter layer 180 includes red, green and blue color filters 182, 184 and 186 respectively corresponding to the red, green and blue pixel regions RP, GP and BP.

The red color filter 182 includes at least one of a red dye and a red pigment, the green color filter 184 includes at least one of a green dye and a green pigment, and the blue color filter 186 includes at least one of a blue dye and a blue pigment.

Although not shown, the gate line and the data line cross each other to define the pixel region, and the switching TFT is formed to be connected to the gate and data lines. The switching TFT is connected to the TFT Tr as the driving element. In addition, the power line, which may be formed to be parallel to and spaced apart from one of the gate and data lines, and the storage capacitor for maintaining the voltage of the gate electrode of the TFT Tr in one frame may be further formed.

A planarization layer 150 is formed on the TFT Tr and the color filter layer 180 and over an entire surface of the substrate 110. The planarization layer 150 has a flat top surface and includes a drain contact hole 152 exposing the drain electrode 142 of the TFT Tr.

The OLED D is disposed on the planarization layer 150 and includes an anode 210, which is connected to the drain electrode 142 of the TFT Tr, an organic emitting layer 220 on the anode 210 and a cathode 230 on the organic emitting layer 220. The OLED D is disposed at each of the red, green and blue pixel regions RP, GP and BP and emits white light in the red, green and blue pixel regions RP, GP and BP.

The anode 210 is separately formed in each of the pixel regions RP, GP and BP. The anode 210 may be formed of a transparent conductive oxide material having a relatively high work function. The anode 210 may be a transparent electrode. For example, the anode 210 may include at least one of indium-tin-oxide (ITO), indium-zinc-oxide (IZO), indium-tin-zinc oxide (ITZO), tin oxide (SnO), zinc oxide (ZnO), indium-copper-oxide (ICO) and aluminum-zinc-oxide (Al:ZnO, AZO).

A bank layer 166 is formed on the planarization layer 150 to cover an edge of the anode 210. Namely, the bank layer 166 is positioned at a boundary of the pixel region and exposes a center of the anode 210 in the pixel region.

Since the OLED D emits blue light in each of the red, green and blue pixel regions RP, GP and BP, the organic emitting layer 220 may be integrally formed as a common layer in the red, green and blue pixel regions RP, GP and BP without separation. The bank layer 166 may be formed to prevent a current leakage at an edge of the anode 210 and may be omitted.

An organic emitting layer 220 is formed on the anode 210. The organic emitting layer 220 includes a first emitting part, which includes a red EML, a second emitting part, which includes a green EML, and a third emitting part, which includes a blue EML. In addition, the organic emitting layer 220 may further include a first charge generation layer (CGL) between the first and second emitting parts and a second CGL between the second and third emitting parts.

The cathode 230 is formed over the substrate 110 where the organic emitting layer 220 is formed. The cathode 230 covers an entire surface of the display area and may be formed of a conductive material having high reflectance. For example, the cathode 230 may be formed of a metallic material, such as aluminum (Al), magnesium (Mg), calcium (Ca), silver (Ag), their alloys or their combinations.

In the OLED D, the anode 210 may be a transparent electrode, and the cathode 230 may be a reflective electrode.

As described below, in the blue pixel region BP, the anode 210 has a pre-determined thickness so that the emitting efficiency in the blue pixel region is improved.

An encapsulation layer (or encapsulation film) is formed on the cathode 230 to prevent penetration of moisture into the OLED D. The encapsulation film includes a first inorganic insulating layer, an organic insulating layer and a second inorganic insulating layer sequentially stacked, but it is not limited thereto.

In addition, a metal plate may be disposed on the encapsulation layer.

The organic light emitting display device 100 may further include a polarization plate for reducing an ambient light reflection. The polarization plate may be disposed under the substrate 110. For example, the polarization plate may be a circular polarization plate.

In FIG. 2, the color filter layer 180 is disposed between the OLED D and the interlayer insulating layer 132. However, a position of the color filter layer 180 is not limited between the OLED D and the substrate 110.

In addition, the organic light emitting display device 100 may further include a color conversion layer between the OLED D and the color filter layer 180. The color conversion layer may include red, green and blue color conversion layers respectively corresponding to the red, green and blue pixel regions RP, GP and BP so that the white light from the OLED D can be converted into red, green and blue light.

As described above, the white light from the OLED passes through the red, green and blue color filters 182, 184 and 186 in the red, green and blue pixel regions RP, GP and BP so that the red, green and blue light can be displayed in the red, green and blue pixel regions RP, GP and BP, respectively.

In FIG. 2, the OLED D emitting the white light is used for a display device. Alternatively, the OLED D may be formed on an entire surface of a substrate without at least one of the driving element and the color filter layer to be used for a lightening device. The display device and the lightening device each including the OLED D of the present disclosure may be referred to as an organic light emitting device.

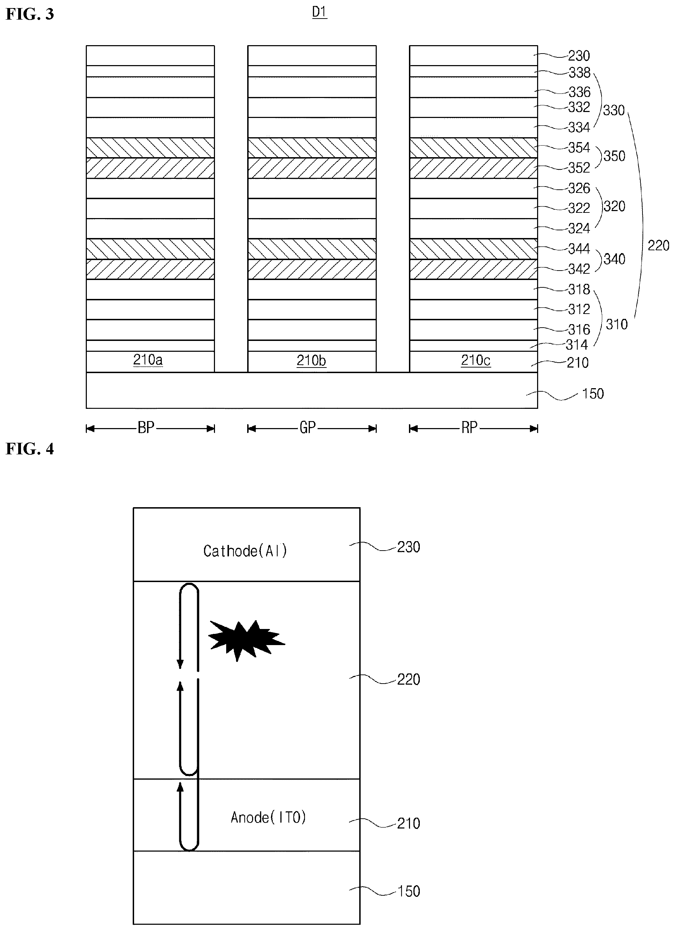

FIG. 3 is a schematic cross-sectional view illustrating an OLED of an organic light emitting display device according to a first embodiment of the present disclosure.

As shown in FIG. 3, the OLED D1 includes an anode 210, a cathode 230 facing the anode 210 and an organic emitting layer 220 between the anode 210 and the cathode 230, and the organic emitting layer 220 includes a first emitting part 310 including a red EML 312, a second emitting part 320 including a green EML 322 and a third emitting part 330 including a blue EML 332. Namely, the OLED D1 has a three-stack structure.

The organic emitting layer 220 may further include a first CGL 340 between the first and second emitting parts 310 and 320 and a second CGL 350 between the second and third emitting parts 320 and 330.

The organic light emitting display device 100 includes red, green and blue pixel regions RP, GP and BP, and the OLED D1 is positioned in the red, green and blue pixel regions RP, GP and BP and emits white light.

The anode 210 includes a first anode 210a in the blue pixel region BP, a second anode 210b in the green pixel region GP and a third anode 210c in the red pixel region RP, and each of the first to third anode 210a, 210b and 210c has the same thickness in a range of 500 to 600Å.

The red EML 312 includes a red host and a red dopant. The red dopant may include one of a fluorescent compound, a phosphorescent compound and a delayed fluorescent compound. In one embodiment of the present disclosure, the red dopant may be a phosphorescent compound. The red EML 312 may have a thickness of 20 to 30nm.

For example, the red host may be selected from the group consisting of mCP-CN, CBP, mCBP, mCP, DPEPO, 2,8-bis(diphenylphosphoryl)dibenzothiophene (PPT), 1,3,5-tri[(3-pyridyl)-phen-3-yl]benzene (TmPyPB), 2,6-di(9H-carbazol-9-yl)pyridine (PYD-2Cz), 2,8-di(9H-carbazol-9-yl)dibenzothiophene (DCzDBT), 3',5'-di(carbazol-9-yl)-[1,1'-bipheyl]-3,5-dicarbonitrile (DCzTPA), 4`-(9H-carbazol-9-yl)biphenyl-3,5-dicarbonitrile (pCzB-2CN), 3`-(9H-carbazol-9-yl)biphenyl-3,5-dicarbonitrile (mCzB-2CN), TSPO1, 9-(9-phenyl-9H-carbazol-6-yl)-9H-carbazole (CCP), 4-(3-(triphenylen-2-yl)phenyl)dibenzo[b,d]thiophene, 9-(4-(9H-carbazol-9-yl)phenyl)-9H-3,9'-bicarbazole, 9-(3-(9H-carbazol-9-yl)phenyl)-9H-3,9'-bicarbazole, 9-(6-(9H-carbazol-9-yl)pyridin-3-yl)-9H-3,9'-bicabazole, 9,9'-diphenyl-9H,9'H-3,3'-bicarbazole (BCzPh), 1,3,5-tris(carbazole-9-yl)benzene (TCP), TCTA, 4,4'-bis(carbazole-9-yl)-2,2'-dimethylbipheyl (CDBP), 2,7-bis(carbazole-9-yl)-9,9-dimethylfluorene (DMFL-CBP), 2,2',7,7'-tetrakis(carbazole-9-yl)-9,9-spiorofluorene (Spiro-CBP), and 3,6-bis(carbazole-9-yl)-9-(2-ethyl-hexyl)-9H-carbazole (TCz1).

The red dopant may be selected from the group consisting of[bis(2-(4,6-dimethyl)phenylquinoline)](2,2,6,6-tetramethylheptane-3,5-dionate)iridium(III), bis[2-(4-n-hexylphenyl)quinoline](acetylacetonate)iridium(III) (Hex-Ir(phq)2(acac)), tris[2-(4-n-hexylphenyl)quinoline]iridium(III) (Hex-Ir(phq)3), tris[2-phenyl-4-methylquinoline]iridium(III) (Ir(Mphq)3), bis(2-phenylquinoline)(2,2,6,6-tetramethylheptene-3,5-dionate)iridium(III) (Ir(dpm)PQ2), bis(phenylisoquinoline)(2,2,6,6-tetramethylheptene-3,5-dionate)iridium(III) (Ir(dpm)(piq)2), bis[(4-n-hexylphenyl)isoquinoline](acetylacetonate)iridium(III) (Hex-Ir(piq)2(acac)), tris[2-(4-n-hexylphenyl)quinoline]iridium(III) (Hex-Ir(piq)3), tris(2-(3-methylphenyl)-7-methyl-quinolato)iridium (Ir(dmpq)3), bis[2-(2-methylphenyl)-7-methylquinoline](acetylacetonate)iridium(III) (Ir(dmpq)2(acac)), bis[2-(3,5-dimethylphenyl)-4-methyl-quinoline](acetylacetonate)iridium(III) (Ir(mphmq)2(acac)), and tris(dibenzoylmethane)mono(1,10-phenanthroline)europium(III) (Eu(dbm)3(phen)).

The first emitting part 310 may further include at least one of a first hole transporting layer (HTL) 316 under the red EML 312 and a first electron transporting layer (ETL) 318 on the first EML 312. In addition, the first emitting part 310 may further include a hole injection layer (HIL) 314 under the first HTL 316.

For example, the first emitting part 310 may have a structure of the HIL 314, the first HTL 316, the red EML 312 and the first ETL 318 sequentially stacked on the anode 210. In this configuration, the HIL 314 may contact the anode 210.

The second emitting part 320 is disposed over the first emitting part 310. Namely, the second emitting part 320 is positioned between the first emitting part 310 and the cathode 230.

The green EML 322 includes a green host and a green dopant. The green dopant may include one of a fluorescent compound, a phosphorescent compound and a delayed fluorescent compound. In one embodiment of the present disclosure, the green dopant may be a phosphorescent compound. The green EML 322 may have a thickness of 30 to 40nm.

For example, the green host may be selected from the group consisting of mCP-CN, CBP, mCBP, mCP, DPEPO, 2,8-bis(diphenylphosphoryl)dibenzothiophene (PPT), TmPyPB, PYD-2Cz, 2,8-di(9H-carbazol-9-yl)dibenzothiophene (DCzDBT), 3',5'-di(carbazol-9-yl)-[1,1'-bipheyl]-3,5-dicarbonitrile (DCzTPA), 4`-(9H-carbazol-9-yl)biphenyl-3,5-dicarbonitrile (pCzB-2CN), 3`-(9H-carbazol-9-yl)biphenyl-3,5-dicarbonitrile (mCzB-2CN), TSPO1, and 9-(9-phenyl-9H-carbazol-6-yl)-9H-carbazole (CCP).

The green dopant may be selected from the group consisting of bis(2-phenylpyridine)](pyridyl-2-benzofuro[2,3-b]pyridine)iridium), tris[2-phenylpyridine]iridium(III) (Ir(ppy)3), fac-tris(2-phenylpyridine)iridium(III) (fac-Ir(ppy)3), bis(2-phenylpyridine)(acetylacetonate)iridium(III) (Ir(ppy)2(acac)), tris[2-(p-tolyl)pyridine]iridium(III) (Ir(mppy)3), bis(2-(naphthalene-2-yl)pyridine)(acetylacetonate)iridium(III) (Ir(npy)2acac), tris(2-phenyl-3-methylpyridine)iidium (Ir(3mppy)3), and fac-tris(2-(3-p-xylyl)phenyl)pyridine iridium(III) (TEG).

The second emitting part 320 may further include at least one of a second HTL 324 under the green EML 322 and a second ETL 326 on the green EML 322.

For example, the second emitting part 320 may have a structure of the second HTL 324, the green EML 322 and the second ETL 326 sequentially stacked over the first emitting part 310.

The third emitting part 330 is disposed over the second emitting part 320. Namely, the third emitting part 330 is positioned between the second emitting part 320 and the cathode 230.

The blue EML 332 includes a blue host and a blue dopant. The blue dopant may include one of a fluorescent compound, a phosphorescent compound and a delayed fluorescent compound. In one embodiment of the present disclosure, the blue dopant may be a fluorescent compound. The blue EML 332 may have a thickness of 20 to 30nm. For example, a thickness of the blue EML 332 may be substantially same as that of the red EML 312, and each of the thickness of each of the blue EML 332 and the red EML 312 may be smaller than that of the green EML 322.

For example, the blue host may be selected from the group consisting of 1,3-bis(carbazol-9-yl)benzene (mCP), 9-(3-(9H-carbazol-9-yl)phenyl)-9H-carbazole-3-carbonitrile (mCP-CN), 3,3'-bis(N-carbazolyl)-1,1'-biphenyl (mCBP), CBP-CN, 9-(3-(9H-Carbazol-9-yl)phenyl)-3-(diphenylphosphoryl)-9H-carbazole (mCPPO1) 3,5-Di(9H-carbazol-9-yl)biphenyl (Ph-mCP), TSPO1, 9-(3'-(9H-carbazol-9-yl)-[1,1'-biphenyl]-3-yl)-9H-pyrido[2,3-b]indole (CzBPCb), bis(2-methylphenyl)diphenylsilane (UGH-1), 1,4-bis(triphenylsilyl)benzene (UGH-2), 1,3-bis(triphenylsilyl)benzene (UGH-3), 9,9-spiorobifluoren-2-yl-diphenyl-phosphine oxide (SPPO1) and 9,9'-(5-(triphenylsilyl)-1,3-phenylene)bis(9H-carbazole) (SimCP).

The blue dopant may be selected from the group consisting of perylene, 4,4'-bis[4-(di-p-tolylamino)styryl]biphenyl (DPAVBi), 4-(di-p-tolylamino)-4,4' -[(di-p-tolylamino)styryl] stilbene (DPAVB), 4,4'-bis[4-(diphenylamino)styryl]biphenyl (BDAVBi), 2,7-bis(4-diphenylamino)styryl)-9,9-spiorfluorene (spiro-DPVBi), [1,4-bis[2-[4-[N,N-di(p-tolyl)amino]phenyl]vinyl] benzene (DSB), 1,4-di-[4-(N,N-diphenyl)amino]styryl-benzene (DSA), 2,5,8,11-tetra-tetr-butylperylene (TBPe), bis(2-hydroxylphenyl)-pyridine)beryllium (Bepp2), 9-(9-Phenylcarbazole-3-yl)-10-(naphthalene-1-yl)anthracene (PCAN), mer-tris(1-phenyl-3-methylimidazolin-2-ylidene-C,C(2)'iridium(III) (mer-Ir(pmi)3), fac-Tris(1,3-diphenyl-benzimidazolin-2-ylidene-C,C(2)'iridium(III) (fac-Ir(dpbic)3), bis(3,4,5-trifluoro-2-(2-pyridyl)phenyl-(2-carboxypyridyl)iridium(III) (Ir(tfpd)2pic), tris(2-(4,6-difluorophenyl)pyridine))iridium(III) (Ir(Fppy)3) and bis[2-(4,6-difluorophenyl)pyridinato-C2,N](picolinato)iridium(III) (FIr-pic).

The third emitting part 330 may further include at least one of a third HTL 334 under the blue EML 332 and a third ETL 336 on the blue EML 332. In addition, the third emitting part 330 may further include an electron injection layer (EIL) 338 on the third ETL 336.

For example, the third emitting part 330 may have a structure of the third HTL 334, the blue EML 332, the third ETL 336 and the EIL 338 sequentially stacked over the second emitting part 320. In this configuration, the EIL 338 may contact the cathode 230.

The HIL 314 may include a hole injection material being at least one compound selected from the group consisting of 4,4',4"-tris(3-methylphenylamino)triphenylamine (MTDATA), 4,4',4"-tris(N,N-diphenyl-amino)triphenylamine (NATA), 4,4',4"-tris(N-(naphthalene-1-yl)-N-phenyl-amino)triphenylamine (1T-NATA), 4,4',4"-tris(N-(naphthalene-2-yl)-N-phenyl-amino)triphenylamine (2T-NATA), copper phthalocyanine(CuPc), tris(4-carbazoyl-9-yl-phenyl)amine (TCTA), N,N'-diphenyl-N,N'-bis(1-naphthyl)-1,1'-biphenyl-4,4"-diamine (NPB or NPD), 1,4,5,8,9,11-hexaazatriphenylenehexacarbonitrile(dipyrazino[2,3-f:2'3'-h]quinoxaline-2,3,6,7,10,11-hexacarbonitrile (HAT-CN), 1,3,5-tris[4-(diphenylamino)phenyl]benzene (TDAPB), poly(3,4-ethylenedioxythiphene)polystyrene sulfonate (PEDOT/PSS), N-(biphenyl-4-yl)-9,9-dimethyl-N-(4-(9-phenyl-9H-carbazol-3-yl)phenyl)-9H-fluoren-2-amine, and N,N'-diphenyl-N,N'-di[4-(N,N-diphenyl-amino)phenyl]benzidine (NPNPB). The HIL 314 may have a thickness of 5 to 15nm

Each of the first to third HTLs 316, 324 and 334 may include a hole transporting material being at least one compound selected from the group consisting of N,N'-diphenyl-N,N'-bis(3-methylphenyl)-1,1'-biphenyl-4,4'-diamine (TPD), NPB (or NPD), 4,4'-bis(N-carbazolyl)-1,1'-biphenyl (CBP), poly[N,N'-bis(4-butylphenyl)-N,N'-bis(phenyl)-benzidine] (poly-TPD), (poly[(9,9-dioctylfluorenyl-2,7-diyl)-co-(4,4'-(N-(4-sec-butylphenyl)diphenylamine))] (TFB), di-[4-(N,N-di-p-tolyl-amino)-phenyl]cyclohexane (TAPC), 3,5-di(9H-carbazol-9-yl)-N,N-diphenylaniline (DCDPA), N-(biphenyl-4-yl)-9,9-dimethyl-N-(4-(9-phenyl-9H-carbazol-3-yl)phenyl)-9H-fluoren-2-amine, N-(biphenyl-4-yl)-N-(4-(9-phenyl-9H-carbazol-3-yl)phenyl)biphenyl-4-amine, and N-([1,1'- biphenyl]-4-yl)-9,9-dimethyl-N-(4-(9-phenl-9H-carbazol-3-yl)phenyl)-9H-fluoren-2-amine.

A thickness of the third HTL 334 may be greater than that of the first HTL 316 and smaller than that of the second HTL 324. For example, the first HTL 316 may have a thickness of 25 to 35nm, the second HTL 324 may have a thickness of 125 to 165nm, and the third HTL 334 may have a thickness of 45 to 85nm.

Each of the first to third ETLs 318, 326 and 336 may include an electron transporting material being at least one compound selected from the group consisting of tris-(8-hydroxyquinoline aluminum (Alq₃), 2-biphenyl-4-yl-5-(4-t-butylphenyl)-1,3,4-oxadiazole (PBD), spiro-PBD, lithium quinolate (Liq), 1,3,5-tris(N-phenylbenzimidazol-2-yl)benzene (TPBi), bis(2-methyl-8-quinolinolato-N1,O8)-(1,1' -biphenyl-4-olato)aluminum (BAlq), 4,7-diphenyl-1,10-phenanthroline (Bphen), 2,9-bis(naphthalene-2-yl)-4,7-diphenyl-1,10-phenanthroline (NBphen), 2,9-dimethyl-4,7-diphenyl-1,10-phenathroline (BCP), 3-(4-biphenyl)-4-phenyl-5-tert-butylphenyl-1,2,4-triazole (TAZ), 4-(naphthalen-1-yl)-3,5-diphenyl-4H-1,2,4-triazole (NTAZ), 1,3,5-tri(p-pyrid-3-yl-phenyl)benzene (TpPyPB), 2,4,6-tris(3'-(pyridin-3-yl)biphenyl-3-yl)1,3,5-triazine (TmPPPyTz), poly[9,9-bis(3'-((N,N-dimethyl)-N-ethylammonium)-propyl)-2,7-fluorene]-alt-2,7-(9,9-dioctylfluorene)]

(PFNBr), tris(phenylquinoxaline) (TPQ), diphenyl-4-triphenylsilyl-phenylphosphine oxide (TSPO1), and 2-[4-(9,10-di-2-naphthalen2-yl-2-anthracen-2-yl)phenyl]-1-phenyl-1H-benzimidazole (ZADN).

A thickness of the first ETL 318 may be greater than that of the second ETL 326 and smaller than that of the third EML 336. For example, the first ETL 318 may have a thickness of 20 to 30nm, the second ETL 326 may have a thickness of 15 to 25nm, and the third ETL 336 may have a thickness of 25 to 35nm.

The EIL 338 may include an electron injection material being at least one of LiF, CsF, NaF, BaF₂, Liq, lithium benzoate and sodium stearate. The EIL 338 may have a thickness of 0.1 to 10nm.

The first CGL 340 is positioned between the first and second emitting parts 310 and 320. Namely, the first and second emitting parts 310 and 320 are connected by the first CGL 340. The first CGL 340 may be a PN-junction layer of a first N-type CGL 342 and a first P-type CGL 344.

The first N-type CGL 342 is positioned between the first ETL 318 and the second HTL 324, and the first P-type CGL 344 is positioned between the first N-type CGL 342 and the second HTL 324.

The second CGL 350 is positioned between the second and third emitting parts 320 and 330. Namely, the second and third emitting parts 320 and 330 are connected by the second CGL 350. The second CGL 350 may be a PN-junction layer of a second N-type CGL 352 and a second P-type CGL 354.

The second N-type CGL 352 is positioned between the second ETL 326 and the third HTL 334, and the second P-type CGL 354 is positioned between the second N-type CGL 352 and the third HTL 334.

Each of the first and second N-type CGLs 342 and 352 may be an organic layer doped with an alkali metal, e.g., Li, Na, K and Cs, and/or an alkali earth metal, e.g., Mg, Sr, Ba and Ra. For example, each of the first and second N-type CGLs 342 and 352 may be formed of an N-type charge generation material including a host being the organic material, e.g., 4,7-dipheny-1,10-phenanthroline (Bphen) and MTDATA, and a dopant being an alkali metal and/or an alkali earth metal, and the dopant may be doped with a weight % of 0.01 to 30. Each of the first and second N-type CGLs 342 and 352 may have a thickness of 10 to 25nm. In one embodiment of the present disclosure, a thickness of the first N-type CGL 342, e.g., 15 to 25nm), may be greater than that of the second N-type CGL 352, e.g., 10 to 20nm.

Each of the first and second P-type CGLs 344 and 354 may be formed of a P-type charge generation material including an inorganic material, e.g., tungsten oxide (Wox), molybdenum oxide (MoOx), beryllium oxide (Be2O3) and vanadium oxide (V2O5), an organic material, e.g., NPD, HAT-CN, F4TCNQ, TPD, TNB, TCTA and N,N'-dioctyl-3,4,9,10-perylenedicarboximide (PTCDI-C8). Each of the first and second P-type CGLs 344 and 354 may have a thickness of 5 to 10nm.

In the OLED D1 in the organic light emitting display device 100 of the present disclosure, the organic emitting layer 220 between the anode 210 and the cathode 230 includes the first emitting part 310 including the red EML 312, the second emitting part 320 positioned between the first emitting part 310 and the cathode 230 and including the green EML 322, and the third emitting part 330 positioned between the second emitting part 320 and the cathode 230 and including the blue EML 332. As a result, the color uniformity of the OLED D1 is improved.

On the other hand, in the three-stack structure OLED including a first emitting part with a red EML, a second emitting part with a green EML and a third emitting part with a blue EML, the blue EML is positioned to be closer to the cathode being a reflective electrode so that the brightness (or luminance) of the blue light is slowly decreased than that of each of the red light and the green light according to a viewing angle. Accordingly, the luminance curves of the red, green and blue colors according to the viewing angle are not matched. In addition, since the OLED includes one blue EML, the luminance of the blue light is lowered and insufficient.

However, in the OLED D1 of the present disclosure, the anode 210 has a thickness in a range of 500 to 600Å, the above problems can be prevented.

Namely, referring to FIG. 4, which is a schematic view illustrating a constructive interference of blue emission in the OLED of the organic light emitting display device according to the first embodiment of the present disclosure, the light from the blue EML 332 may be divided into a light reflected by the cathode 230 as the reflective electrode, a light reflected at an interface between the organic emitting layer 220 and the anode 210 as a transparent electrode, and a light reflected at an interface between the anode 210 and the planarization layer 150, the blue light efficiency at a front viewing angle is improved and a decreasing speed of the blue light luminance according to the viewing angle is increased when the constructive interference between the light reflected at an interface between the organic emitting layer 220 and the anode 210 and the light reflected at an interface between the anode 210 and the planarization layer 150 occurs.

For this constructive interference, a thickness "T" of the anode 210 should be 1/4 of a blue light wavelength (λ_{B}/n) in a medium (the anode), i.e., 500 to 600Å. (T=(λ_{B}/n)/4, λ_{B}=a wavelength of blue light, n=a refractive index of an anode)

Accordingly, in the organic light emitting display device 100, the emitting efficiency of the blue color is improved, and the luminance deviation in wavelength ranges according to a viewing angle is decreased.

On the other hand, when the anode 210 in the red, green and blue pixel regions RP, GP and BP has the same thickness in a range of 500 to 600Å, a cavity effect for the green color is not provided so that there is a problem of mismatching of the luminance curves in the blue color and the green color.

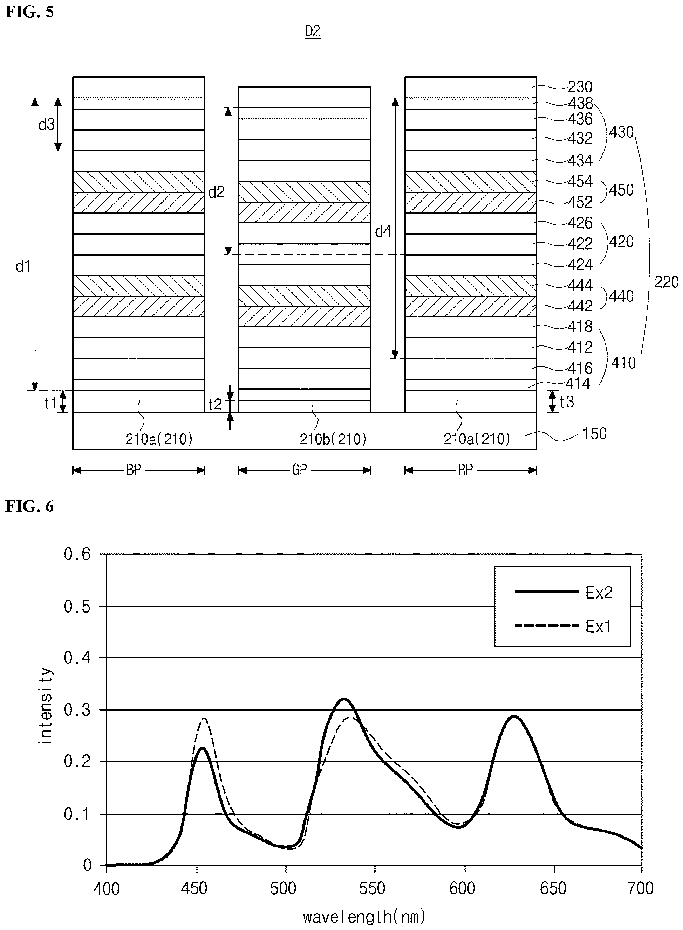

FIG. 5 is a schematic cross-sectional view illustrating an OLED of an organic light emitting display device according to a second embodiment of the present disclosure.

As shown in FIG. 5, the OLED D2 includes an anode 210, a cathode 230 facing the anode 210 and an organic emitting layer 220 between the anode 210 and the cathode 230, and the organic emitting layer 220 includes a first emitting part 410 including a red EML 412, a second emitting part 420 including a green EML 422 and a third emitting part 430 including a blue EML 432. Namely, the OLED D2 has a three-stack structure.

The organic emitting layer 220 may further include a first CGL 440 between the first and second emitting parts 410 and 420 and a second CGL 450 between the second and third emitting parts 420 and 430.

The organic light emitting display device 100 includes red, green and blue pixel regions RP, GP and BP, and the OLED D2 is positioned in the red, green and blue pixel regions RP, GP and BP and emits white light.

The anode 210 includes a first anode 210a in the blue pixel region BP, a second anode 210b in the green pixel region GP and a third anode 210c in the red pixel region RP, and the first to third anode 210a, 210b and 210c have a difference in a thickness.

Namely, the first anode 210a has a first thickness t1, and the second anode 210b has a second thickness t2 being 2/5 to 2/3 of the first thickness t1. In one embodiment of the present disclosure, the second thickness t2 may be 1/2 of the first thickness t1. The first thickness t1 may be in a range of 500 to 600Å, and the second thickness t2 may be in a range of 200 to 400Å. In one embodiment of the present disclosure, the first thickness t1 may be 600Å, and the second thickness t2 may be 300Å. The third anode 210c may have a third thickness t3 being same as the first thickness t1 or the second thickness t2. But embodiments of the present disclosure are not limited thereto. In embodiments of the present disclosure, the first thickness t1 of the first anode 210a in the blue pixel region BP can be greater than the second thickness t2 of the second anode 210b in the green pixel region GP, and in turn, the first thickness t1 of the first anode 210a in the blue pixel region BP can be greater than or equal to the third thickness t3 of the third anode 210a in the red pixel region RP. Accordingly, the third thickness t3 of the third anode 210 is not the thinnest of three anodes respectively in the blue, green and red pixel regions. Instead, the second thickness t2 of the second anode 210b in the green pixel region GP is the thinnest of the three anodes.

As a result, the OLED D2 has high color gamut with 85% overlapping ratio in the color range standard BT 2020 and provide high emitting efficiency of green color.

A first distance d1 from a lower surface of the cathode 230 to an upper surface of the anode 210 is in a range of 455 to 485nm, and a second distance d2 from the lower surface of the cathode 230 to a lower surface of the green EML 422 is in a range of 180 to 230nm. As a result, the emitting efficiency of green color in the OLED D2 is improved. But embodiments of the present disclosure are not limited thereto. For example, the first distance d1 from the cathode 230 to the anode 210 of the organic light emitting diode OLED D1 or OLED D2 can be approximately equal in each of the red pixel region RP, the green pixel region GP and the blue pixel region BP. In this context, a first travel distance of a blue light from the blue emitting material layer 432 to a distal surface (surface abutting the planarization layer 150, for example) of the anode 210a in the blue pixel region BP can be greater than a second travel distance of a blue light from the blue emitting material layer 432 to a distal surface of the anode 210b in the green pixel region GP.

A third distance d3 from the lower surface of the cathode 230 to a lower surface of the blue EML 432 is in a range of 45 to 65nm, and a fourth distance d4 from the lower surface of the cathode 230 to a lower surface of the red EML 412 is in a range of 415 to 445nm.

The red EML 412 includes a red host and a red dopant. The red dopant may include one of a fluorescent compound, a phosphorescent compound and a delayed fluorescent compound. In one embodiment of the present disclosure, the red dopant may be a phosphorescent compound. The red EML 412 may have a thickness of 20 to 30nm.

The red host may be the above-mentioned red host material, and the red dopant may be the above-mentioned red dopant material.

The first emitting part 410 may further include at least one of a first hole transporting layer (HTL) 416 under the red EML 412 and a first electron transporting layer (ETL) 418 on the first EML 412. In addition, the first emitting part 410 may further include a hole injection layer (HIL) 414 under the first HTL 416.

For example, the first emitting part 410 may have a structure of the HIL 414, the first HTL 416, the red EML 412 and the first ETL 418 sequentially stacked on the anode 210. In this configuration, the HIL 414 may contact the anode 210.

The second emitting part 420 is disposed over the first emitting part 410. Namely, the second emitting part 420 is positioned between the first emitting part 410 and the cathode 230.

The green EML 422 includes a green host and a green dopant. The green dopant may include one of a fluorescent compound, a phosphorescent compound and a delayed fluorescent compound. In one embodiment of the present disclosure, the green dopant may be a phosphorescent compound. The green EML 422 may have a thickness of 30 to 40nm.

The green host may be the above-mentioned green host material, and the green dopant may be the above-mentioned green dopant material.

The second emitting part 420 may further include at least one of a second HTL 424 under the green EML 422 and a second ETL 426 on the green EML 422.

For example, the second emitting part 420 may have a structure of the second HTL 424, the green EML 422 and the second ETL 426 sequentially stacked over the first emitting part 410.

The third emitting part 430 is disposed over the second emitting part 420. Namely, the third emitting part 430 is positioned between the second emitting part 420 and the cathode 230.

The blue EML 432 includes a blue host and a blue dopant. The blue dopant may include one of a fluorescent compound, a phosphorescent compound and a delayed fluorescent compound. In one embodiment of the present disclosure, the blue dopant may be a fluorescent compound. The blue EML 432 may have a thickness of 20 to 30nm. For example, a thickness of the blue EML 432 may be substantially same as that of the red EML 412, and each of the thickness of each of the blue EML 432 and the red EML 412 may be smaller than that of the green EML 422.

The blue host may be the above-mentioned blue host material, and the blue dopant may be the above-mentioned blue dopant material.

The third emitting part 430 may further include at least one of a third HTL 434 under the blue EML 432 and a third ETL 436 on the blue EML 432. In addition, the third emitting part 430 may further include an electron injection layer (EIL) 438 on the third ETL 436.

For example, the third emitting part 430 may have a structure of the third HTL 434, the blue EML 432, the third ETL 436 and the EIL 438 sequentially stacked over the second emitting part 420. In this configuration, the EIL 438 may contact the cathode 230.

The HIL 414 may include the above-mentioned hole injection material and may have a thickness of 5 to 15nm

Each of the first to third HTLs 416, 424 and 434 may include the above-mentioned hole transporting material. A thickness of the third HTL 434 may be greater than that of the first HTL 416 and smaller than that of the second HTL 424. For example, the first HTL 416 may have a thickness of 25 to 35nm, the second HTL 424 may have a thickness of 125 to 165nm, and the third HTL 434 may have a thickness of 45 to 85nm.

Each of the first to third ETLs 418, 426 and 436 may include the above-mentioned electron transporting material. A thickness of the first ETL 418 may be greater than that of the second ETL 426 and smaller than that of the third ETL 436. For example, the first ETL 418 may have a thickness of 20 to 30nm, the second ETL 426 may have a thickness of 15 to 25nm, and the third ETL 436 may have a thickness of 25 to 35nm.

The EIL 438 may include the above-mentioned electron injection material and may have a thickness of 0.1 to 10nm.

The first CGL 440 is positioned between the first and second emitting parts 410 and 420. Namely, the first and second emitting parts 410 and 420 are connected by the first CGL 440. The first CGL 440 may be a PN-junction layer of a first N-type CGL 442 and a first P-type CGL 444.

The first N-type CGL 442 is positioned between the first ETL 418 and the second HTL 424, and the first P-type CGL 444 is positioned between the first N-type CGL 442 and the second HTL 424.

The second CGL 450 is positioned between the second and third emitting parts 420 and 430. Namely, the second and third emitting parts 420 and 430 are connected by the second CGL 450. The second CGL 450 may be a PN-junction layer of a second N-type CGL 452 and a second P-type CGL 454.

The second N-type CGL 452 is positioned between the second ETL 426 and the third HTL 434, and the second P-type CGL 454 is positioned between the second N-type CGL 452 and the third HTL 434.

Each of the first and second N-type CGLs 442 and 452 may include the above-mentioned N-type charge generation material and may have a thickness of 10 to 25nm. In one embodiment of the present disclosure, a thickness of the first N-type CGL 442, e.g., 15 to 25nm), may be greater than that of the second N-type CGL 452, e.g., 10 to 20nm.

Each of the first and second P-type CGLs 444 and 454 may include the above-mentioned P-type charge generation material and may have a thickness of 5 to 10nm.

In the OLED D2 in the organic light emitting display device 100 of the present disclosure, the first anode 210a in the blue pixel region BP has a first thickness t1 in a range of 500 to 600Å, and the second anode 210b in the green pixel region GP has a second thickness t2 being 2/5 to 2/3 of the first thickness t1. As result, the OLED D2 has high color gamut with 85% overlapping ratio in the color range standard BT 2020 and provide high emitting efficiency of green color.

In addition, since the lower surface of the green EML 422 is spaced apart from a lower surface of the cathode 230 by the second distance d2, i.e., 180 to 230nm, the emitting efficiency of green color in the OLED D2 is further improved.

### [OLED1]

An anode (ITO), an HIL (10nm), a first HTL (30nm), a red EML (25nm), a first ETL (25nm), a first N-type CGL (20nm), a first P-type CGL (10nm), a second HTL (145nm), a green EML (40nm), a second ETL (20nm), a second N-type CGL (15nm), a second P-type CGL (10nm), a third HTL (65nm), a blue EML (25nm), a third ETL (30nm), an EIL (1nm), and a cathode (Al, 50nm) were sequentially stacked to form a white OLED.

### (1) Example 1 (Ex1)

The anodes in the red, green and blue pixel regions were formed with the same thickness (600Å).

### (2) Example 2 (Ex2)

The anodes in the red, green and blue pixel regions were formed with the same thickness (300Å).

The emission intensity in wavelength ranges of the OLED in Examples 1 and 2 are measured and shown in FIG. 6.

As shown in FIG. 6, in the OLED with the anode having a thickness of 600Å, the luminance (emission intensity) of the blue color light is increased. On the other hand, in the OLED with the anode having a thickness of 300Å, the luminance (emission intensity) of the green color light is increased. The luminance of the red color light seems not to depend on a thickness of the anode and may be substantially constant.

### (3) Example 3 (Ex3)

In the OLED of Example 1, the anode in the green pixel region is formed with a thickness "T" of 600Å, 500Å, 400Å, 300Å, 200Å and 100Å.

The emitting efficiency (cd/A), the color coordinate index (CIE) and the color gamut (CG) of the OLED in Example 3 are listed in Table 1. The color gamut is an overlapping % in the color range standard BT 2020.

**Table 1**

| | | | | | | | |
|---|---|---|---|---|---|---|---|
| T (Å) | R | 600 | 600 | 600 | 600 | 600 | 600 |
| | G | 600 | 500 | 400 | 300 | 200 | 100 |
| | B | 600 | 600 | 600 | 600 | 600 | 600 |
| cd/A | R | 20.9 | 20.9 | 20.9 | 20.9 | 20.9 | 20.9 |
| | G | 41.5 | 45.4 | 48.3 | 49.8 | 49.6 | 47.5 |
| | B | 2.5 | 2.5 | 2.5 | 2.5 | 2.5 | 2.5 |
| | W | 112.7 | 112.7 | 112.7 | 112.7 | 112.7 | 112.7 |
| CIE | Rx | 0.694 | 0.694 | 0.694 | 0.694 | 0.694 | 0.694 |
| | Ry | 0.308 | 0.308 | 0.308 | 0.308 | 0.308 | 0.308 |
| | Gx | 0.241 | 0.241 | 0.241 | 0.240 | 0.239 | 0.237 |
| | Gy | 0.725 | 0.725 | 0.724 | 0.723 | 0.721 | 0.720 |
| | Bx | 0.149 | 0.149 | 0.149 | 0.149 | 0.149 | 0.149 |
| | By | 0.046 | 0.046 | 0.046 | 0.046 | 0.046 | 0.046 |
| CG | BT2020 | 85.0 | 85.0 | 85.0 | 85.0 | 85.0 | 85.0 |

As shown in Table 1, in the OLED with the anode in the green pixel with a thickness of 200 to 400Å, the OLED has high emitting efficiency in the green color with desired color gamut and color coordinate index.

Namely, as the OLED D2 of the present disclosure, when a first thickness t1 of the first anode 210a in the blue pixel region is 1/4 of a blue wavelength (λ_{B}/n) in the anode and a second thickness t2 of the second anode 210b in the green pixel region is 2/5 to 2/3 of the first thickness t1, the luminance of the blue color and the luminance of the green color are increased.

In addition, the luminance curves of the blue color and the green color according to viewing angles are matched so that the display quality of the organic light emitting display device 100 is improved.

### [OLED2]

After a first anode (ITO, 600Å), a second anode (ITO, 300Å) and a third anode (ITO, 600Å) were formed in the blue, green and red pixel regions, respectively, an HIL (10nm), a first HTL (30nm), a red EML (25nm), a first ETL (25nm), a first N-type CGL (20nm), a first P-type CGL (10nm), a second HTL, a green EML (40nm), a second ETL (20nm), a second N-type CGL (15nm), a second P-type CGL (10nm), a third HTL, a blue EML (25nm), a third ETL (30nm), an EIL (1nm), and a cathode (Al, 50nm) were sequentially stacked on the first to third anodes to form a white OLED.

### (4) Example 4 (Ex4)

The second HTL was formed with a thickness of 185nm, and the third HTL was formed with a thickness of 25nm.

### (5) Example 5 (Ex5)

The second HTL was formed with a thickness of 165nm, and the third HTL was formed with a thickness of 45nm.

### (6) Example 6 (Ex6)

The second HTL was formed with a thickness of 145nm, and the third HTL was formed with a thickness of 65nm.

### (7) Example 7 (Ex7)

The second HTL was formed with a thickness of 125nm, and the third HTL was formed with a thickness of 85nm.

### (8) Example 8 (Ex8)

The second HTL was formed with a thickness of 105nm, and the third HTL was formed with a thickness of 105nm.

The emitting efficiency (cd/A), the color coordinate index (CIE) and the color gamut (CG) of the OLED in Examples 4 to 8 are listed in Table 2. The color gamut is an overlapping % in the color range standard BT 2020.

**Table 2**

| | | Ex4 | Ex5 | Ex6 | Ex7 | Ex8 |
|---|---|---|---|---|---|---|
| cd/A | R | 20.9 | 20.9 | 20.9 | 20.9 | 20.9 |
| | G | 18.2 | 36.9 | 48.0 | 44.4 | 28.7 |
| | B | 2.5 | 2.5 | 2.5 | 2.5 | 2.5 |
| | W | 112.7 | 112.7 | 112.7 | 112.7 | 112.7 |
| CIE | Rx | 0.694 | 0.694 | 0.694 | 0.694 | 0.694 |
| | Ry | 0.308 | 0.308 | 0.308 | 0.308 | 0.308 |
| | Gx | 0.191 | 0.218 | 0.236 | 0.253 | 0.274 |
| | Gy | 0.743 | 0.736 | 0.726 | 0.714 | 0.694 |
| | Bx | 0.149 | 0.149 | 0.149 | 0.149 | 0.149 |
| | By | 0.046 | 0.046 | 0.046 | 0.046 | 0.046 |
| CG | BT2020 | 88.2 | 86.6 | 85.3 | 83.9 | 81.9 |

As shown in Table 2, in the OLED of Examples 5 to 7, in which a lower surface of the green EML is spaced apart from the cathode as a reflective electrode by a distance of 180 to 230nm, the OLED has high green emitting efficiency with sufficient color gamut.

It will be apparent to those skilled in the art that various modifications and variations can be made in the embodiments of the present disclosure without departing from the scope of the present disclosure. Thus, it is intended that the modifications and variations cover this disclosure provided they come within the scope of the appended claims and their equivalents.

## Claims

1. An organic light emitting device, comprising:
a substrate (110) including red, green and blue pixel regions (RP, GP, BP); and
an organic light emitting diode (D) including an anode (210), a cathode (230) over the anode (210) and an organic emitting layer (220) between the anode (210) and the cathode (230) and corresponding to in the red, green and blue pixel regions (RP, GP, BP),
wherein the organic emitting layer (220) includes a first emitting part (310) including a red emitting material layer (312), a second emitting part (320) including a green emitting material layer (322) and positioned between the first emitting part (310) and the cathode (230) and a third emitting part (330) including a blue emitting material layer (332) and positioned between the second emitting part (320) and the cathode (230), and
wherein the anode (210a) in the blue pixel region (BP) has a first thickness (t1), and the anode (210b) in the green pixel region (GP) has a second thickness (t2) being 2/5 to 2/3 of the first thickness (11).

2. The organic light emitting device according to claim 1, wherein the first thickness (t1) is 1/4 of a blue wavelength in the anode (210) wherein the blue wavelength in the anode means λ_{B}/n, wherein λ_{B} is a wavelength of the blue light, n is a refractive index of the anode (210).

3. The organic light emitting device according to claim 1 or 2, wherein the first thickness (T1) is in a range of 500 to 600Å.

4. The organic light emitting device according to any one of the claims 1, 2 or 3, wherein the second thickness (t2) is in a range of 200 to 400Å.

5. The organic light emitting device according to any one of the preceding claims, wherein a distance between a lower surface of the green emitting material layer (322) and a lower surface of the cathode (230) is in a range of 180 to 230nm.

6. The organic light emitting device according to any one of the preceding claims, wherein a distance between a lower surface of the blue emitting material layer (332) and a lower surface of the cathode (230) is in a range of 45 to 65nm, and a distance between a lower surface of the red emitting material layer (312) and a lower surface of the cathode (230) is in a range of 415 to 445nm.

7. The organic light emitting device according to any one of the preceding claims"
wherein the first emitting part (310) further includes a first hole transporting layer (316) under the red emitting material layer, a hole injection layer (314) under the first hole transporting layer (316) and a first electron transporting layer (318) on the red emitting material layer (312),
wherein the second emitting part (320) further includes a second hole transporting layer (324) under the green emitting material layer (322) and a second electron transporting layer (326) on the green emitting material layer (322), and
wherein the third emitting part (330) further includes a third hole transporting layer (334) under the blue emitting material layer (332), a third electron transporting layer (336) on the blue emitting material layer (332) and an electron injection layer (338) on the third electron transporting layer (336).

8. The organic light emitting device according to claim 7, wherein a thickness of the third hole transporting layer (334) is greater than a thickness of the first hole transporting layer (314) and is smaller than a thickness of the second hole transporting layer (324).

9. The organic light emitting device according to claim 7 or 8, wherein the thickness of the second hole transporting layer (324) is in a range of 125 to 165nm, and the thickness of the third hole transporting layer (334) is in a range of 45 to 85nm.

10. The organic light emitting device according to any one of the claims 7, 8 or 9, wherein the thickness of the first hole transporting layer (314) is in a range of 25 to 35nm, the thickness of the second hole transporting layer (324) is in a range of 125 to 165nm, and the thickness of the third hole transporting layer (343)is in a range of 45 to 85nm.

11. The organic light emitting device according to any one of the claims 7-10, wherein a thickness of the first electron transporting layer (316) is greater than a thickness of the second electron transporting layer (326) and is smaller than a thickness of the third electron transporting layer (336).

12. The organic light emitting device according to any one of the claims 7-11, wherein the thickness of the first electron transporting layer (316) is a range of 20 to 30nm, the thickness of the second electron transporting layer (326) is a range of 15 to 25nm, and the thickness of the third electron transporting layer (336) is a range of 25 to 35nm.

13. The organic light emitting device according to any one of the preceding claims, wherein the anode (210c) in the red pixel region (RP) has a third thickness (t3) being same as the first thickness (t1) or the second thickness (t2).

14. The organic light emitting device according to any one of the preceding claims, wherein the organic emitting layer (220) further includes a first charge generation layer (340) between the first and second emitting parts (310, 320) and a second charge generation layer (350) between the second and third emitting parts (320, 330).

15. The organic light emitting device according to any one of the preceding claims, further comprising a color filter layer (180) corresponding to the red, green and blue pixel regions (RP, GP, BP) and positioned between the substrate (110) and the organic light emitting diode (D).
